# EUROPEAN PATENT SPECIFICATION

(11) **EP 0 348 046 B1**
(45) Date of publication and mention of the grant of the patent: **28.08.1996**
(21) Application number: 89305353.8
(22) Date of filing: 26.05.1989
(51) Int. Cl.: H01L 27/108, H01L 21/82

(54) **Method of producing a semiconductor device**
Herstellungsverfahren einer Halbleitervorrichtung
Méthode de fabrication d'un dispositif semi-conducteur

(30) Priority: 28.05.1988 JP 129463/88
(43) Date of publication of application: 27.12.1989
(73) Proprietor: FUJITSU LIMITED, Kawasaki-shi, Kanagawa 211 (JP)
(72) Inventor: Gotou, Hiroshi, Niiza-shi Saitama 352 (JP)
(74) Representative: Stebbing, Timothy Charles

(56) References cited:
- EP-A- 0 198 590
- EP-A- 0 333 426
- DE-A- 3 801 525
- IBM TECHNICAL DISCLOSURE BULLETIN, vol. 30, no. 5, October 1987, pages 406-408, New York, US; "High density cross-point cell in an interleaved sense amplifier layout"

## Description

The present invention relates to a method of manufacturing a semiconductor device, and more particularly, to a method of manufacturing a semiconductor memory device wherein a head portion of a semiconductor pillar having a conductive side wall is brought into contact with a conductive pattern.

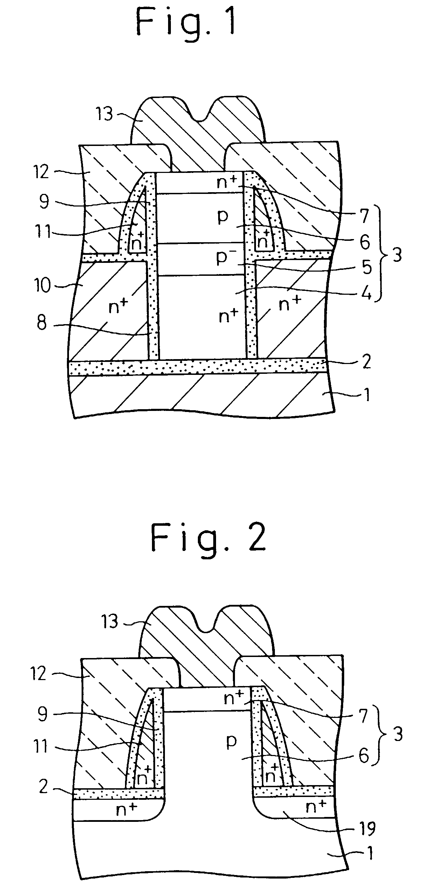

Figures 1 and 2, respectively, show cross-sectional views of a pillar-shaped DRAM (Dynamic Random Access Memory) and a ROM (Read Only Memory) of a prior proposal.

In Fig. 1 a SiO₂ film 2 is formed on a silicon substrate 1, and a semiconductor pillar 3 is formed on the SiO₂ film 2 and consists of a first conductive layer (storage electrode) 4, p⁻ type Si layer 5, channel doped layer 6, and a second conductive layer (drain) 7. The DRAM of Fig. 1 further comprises a dielectric film 8, a gate insulating film (SiO₂) 9, a third conductive layer (electrode) 10, a polysilicon word line (gate) 11, an interlaminar insulating film such as a PSG film, etc., and an aluminum bit line 13.

Further, as shown in Figure 2, the ROM comprises a silicon substrate 1 having an n⁺ source region 19, a p channel region 6 and an n⁺ drain region 7, dielectric film 2, a gate insulating film 9, a doped polysilicon gate electrode (word line), a PSG interlaminar insulating film 12, and an aluminum bit line 13. The channel region 6 and the drain region 7 form a semiconductor pillar 3 on a portion of the source region 19.

To bring the semiconductor pillar 3 into contact with the bit line 13, a contact hole is formed in the interlaminar insulating film 12, by a photolithography process as shown in Figs 1 and 2. In the process of forming the contact holes, the contact hole must lie within the second conductive layer 7 or the drain region 7, and accordingly the whole head portion of the semiconductor pillar cannot be used for the contact; thus the diameter of the semiconductor pillar must be enlarged.

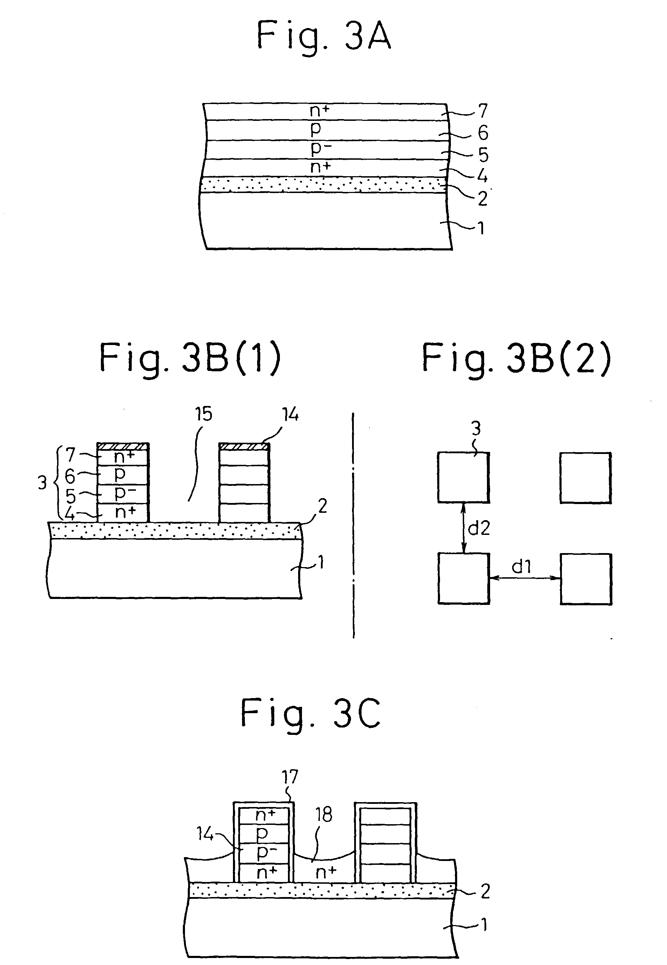

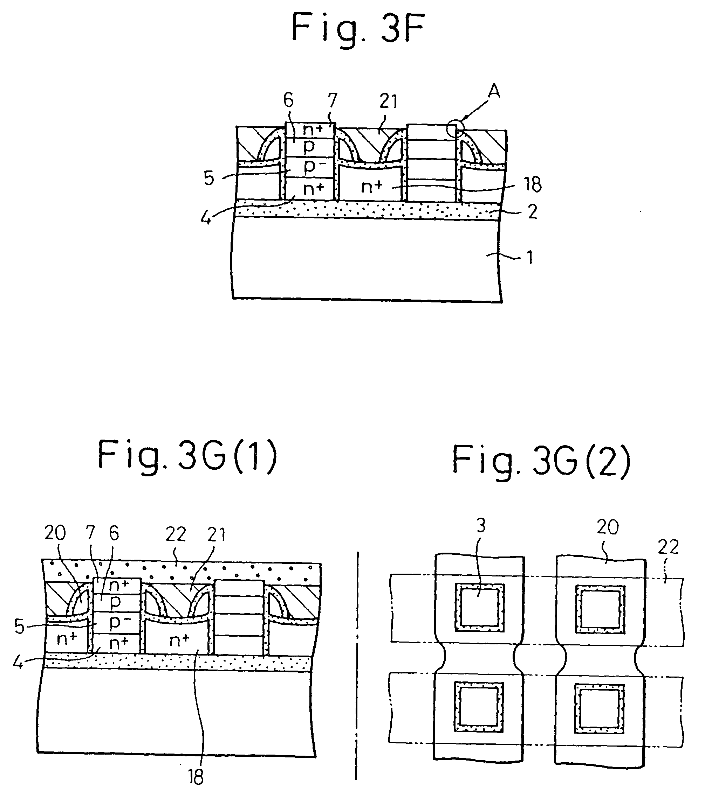

Figures 3A to 3G show cross-sectional step views of the production of another DRAM cell according to another prior proposal.

First, as shown in Fig. 3A, a SiO₂ film 2 having a thickness of 0.5 µm, an n⁺ conductive layer 4, a p⁻ silicon layer 5 having a thickness of 5 µm, a p channel doped layer 6, and an n⁺ conductive layer 7 are formed on a silicon substrate 1.

Then, as shown in Figure 3B(1),a trench 15 is formed by etching the semiconductor layers (7, 6, 5 and 4) by an RIE process using an oxide film 14 as a mask. Each semiconductor pillar 3 obtained by the etching has a top surface cross section of 0.7 µm by 0.7 µm and the gap (d1) between pillars in the X-direction is greater than that (d2) in the Y-direction, as shown in a top view of Fig. 3B(2). Then, as shown in Fig. 3C, after removing the mask 14, a SiO₂ film 17 and n⁺ poly Si film 18 are formed and the exposed SiO₂ film 17 is etched by hydrofluoric acid so that only a dielectric SiO₂ film remains.

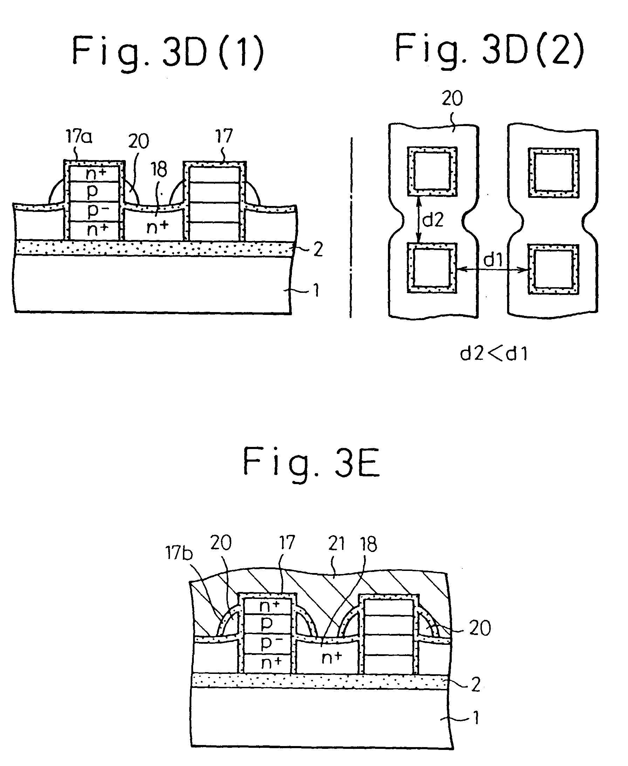

Then, as shown in Fig. 3D(1), the substrate is thermally oxidized and a gate SiO₂ film 17a having a thickness of 200 Å (200 Å = 20 nm) is formed. Further, after forming a poly Si film by a CVD process on the exposed surface of the substrate, the poly Si film is etched back by an RIE process so that a side wall poly Si film 20, which becomes a gate electrode,remains. Asexplained above, different gaps are set up between the pillars, i.e., dl is larger than d2 as shown in Fig. 3D(2).

Then, as shown in Fig. 3E, a SiO₂ film 17B is formed by thermal oxidation and phospho-silicate-glass (PSG) or SiO₂ deposited over the entire surface of the substrate by a CVD process.

Then, as shown in Fig. 3F, the deposited PSG or SiO₂ layer 21 is etched back until the top surface of the semiconductor pillar is exposed.

Then an aluminum film is deposited and patterned so that a bit line 22 is formed, the bit line 22 and the n⁺ conductive layer 7 in the semiconductor pillar being connected by a self-alignment process. The above descriptive is of a DRAM realized by a prior art process, and in the etching back process shown in Fig. 3F the end point of the etching, wherein the semiconductor pillar is exposed, is not easily found, and therefore, since overetching often occurs, the SiO₂ film at A in Fig. 3F is also etched, whereby a desired thickness of the SiO₂ film cannot be obtained and the breakdown voltage is lowered.

An example of a DRAM pillar array is provided by DE-A-3801525 (Mitsubishi) where polysilicon sidewall gates are applied and silicon oxide layers are deposited and etched to planarise the surface. No indication is given as to how to control the etch-back process. In EP-A-198590 pillars are likewise formed, with polysilicon gates on their walls shaped by anisotropic etching; here no planarisation takes place, the drain contacts being made through etched contact holes.

An object of the present invention is to provide a method of manufacturing a semiconductor device wherein a conductive pattern such as a bit line or like conductor is brought into contact with a semiconductor pillar formed on a semiconductor substrate, by a self-alignment process.

Another object of the present invention is to provide a method of manufacturing a semiconductor device, such as a DRAM cell structure, wherein the semiconductor pillar formed on a semiconductor substrate has a small diameter.

Therefore, according to the present invention there is provided a method of producing a semiconductor device, comprising the steps of: preparing a semiconductor substrate, forming a semiconductor pillar projecting from the semiconductor substrate so as to have a head portion surface and a circumferential surface, forming a first insulating layer on the head portion surface of the semiconductor pillar, forming a second insulating layer on the circumferential surface of the semiconductor pillar, forming a conductive side wall on the circumference of the semiconductor pillar on the second insulating layer, forming a third insulating layer, of a material different from that of the first insulating layer, on the surface of the conductive side wall, forming a fourth insulating layer, of a material different from that of the first insulating layer, on the entire exposed surface so that the semiconductor pillar and the conductive side wall are buried, removing the fourth insulating layer to the level of the first insulating layer on the head portion surface of the semiconductor pillar, selectively growing a layer of insulation on the upper portion of the conductive side wall, without causing such growth on the semiconductor pillar, by using the first insulating layer as a mask, whereby the breakdown voltage between the conductive side wall and other elements is improved, removing at least one part of the first insulating layer formed on the head portion of the semiconductor pillar, and forming a conductive pattern on the head portion of the semiconductor pillar and the fourth insulating layer.

Reoxidation of the top part of an insulating sidewall on a polysilicon layer is known in itself; see for instance IBM TDB Vol 30 no. 5, pages 406-408. However, no advantage is taken here, as it is in the invention, of applying this technique to make a self-aligned contact to a pillar in a planarised construction.

### BRIEF DESCRIPTION OF THE DRAWINGS

Figures 1 and 2 are, respectively, cross-sectional views of a pillar-shaped DRAM and a ROM of a prior proposal;
Figs. 3A to 3G are cross-sectional step views of the production of another DRAM cell according to another prior proposal;
Figs. 4A to 4F are cross sectional step views of the production of an example according to the present invention;
Figs. 5 and 6 are cross-sectional views of a DRAM and a ROM embodying the present invention.

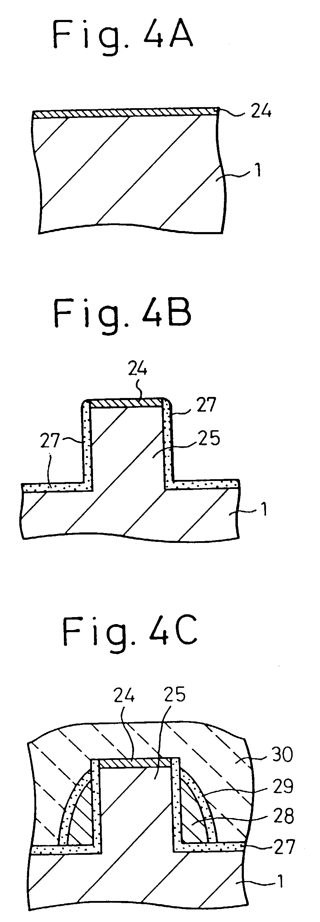

An example of the present invention will now be explained with reference to Figures 4A to 4F.

Figures 4A to 4F show cross-sectional process views of an embodiment of the present invention.

First, as shown in Fig. 4A, silicon nitride (Si₃N₄) film 24 having a thickness of about 0.15 µm is formed on a surface of a silicon substrate 1, by a usual CVD (chemical vapour deposition) process. The Si₃N₄ film 24 acts as an antioxidant film in an oxidizing process carried out at a later stage.

Then, the upper portion of the silicon substrate 1 is etched to form a projecting pillar portion; for example,a resist pattern (not shown) is formed on a desiredportion of the surface of the Si₃N₄ film 24, and, using the resist pattern as a mask, the Si₃N₄ film 24 and the silicon substrate 1 respectively are selectively etched. The pillar-shaped silicon thickness 25 is, for example, about 2.0 µm. After forming the pillar-shaped silicon 25 with the Si₃N₄ film 24, the exposed surface of the pillar-shaped silicon 25 is oxidized to form an oxide film 27 having a thickness of about 300 Å, as shown in Fig. 4B.

Then a conductive side wall 28 is formed on the oxide film 27 of the pillar-shaped silicon 25. The conductive side wall is formed by the steps of depositing a polysilicon on an entire exposed surface, implanting n type impurities (dopant) therein, and diffusing same, and carrying out an anisotropic etching using reactive ion etching so that the polysilicon remains on only the side wall of the pillar-shaped silicon, whereby the polysilicon side wall 28 is formed. Then the surface of the polysilicon side wall 28 is oxidized to form an oxide film 29, and subsequently, a PSG or SiO₂ layer 30 is formed on the entire exposed surface as an interlaminar insulating film so that the semiconductor pillar 25 is buried as shown in Fig. 4C.

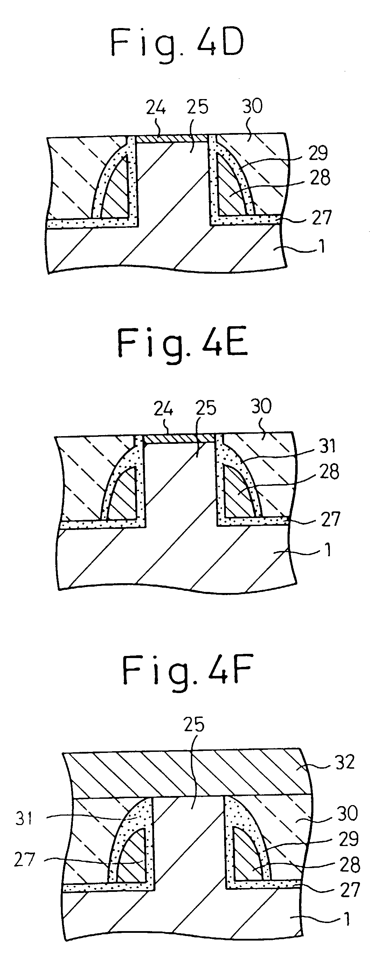

Then, as shown in Fig. 4D, the PSG or SiO₂ layer 30 is etched back so that the surface of the Si₃N₄ film 24 is exposed, with the result that the top surfaces of the pillar-shaped silicon 25 and the interlaminar insulating film 30 form a continuous flat surface.

If,after removing the Si₃N₄ film 24, an aluminum wiring is formed on the resulting surface of the silicon pillar 25, contact between the silicon pillar and the wiring can be realized by a self alignment process and without the need for mask alignment.

When the aluminum wiring is formed by such steps, however, a semiconductor element is apt to be faulty due to a low breakdown voltage between the aluminum wiring and the polysilicon side wall 28. The low breakdown voltage exists because when the PSG film 30 is etched back to the PSG film 30 positioned at the top portion of the polysilicon side wall 28, and subsequently a part of oxide film 29, is etched whereby an insulating film having a thickness sufficient to withstand the breakdown voltage is no longer present.

According to the present invention, after exposing the Si₃N₄ film 24, to prevent the above-mentioned overetching, an oxidizing treatment is additionally carried out since, during this oxidizing treatment, the Si₃N₄ film 24 acts as an antioxidizing film, and thus the pillar-shaped silicon 25 is not oxidized. Further, since the PSG film 30 and the oxide film 29 has been oxidized, the polysilicon side wall 28 is oxidized from the top portion thereof downward, and thus the top portion of the polysilicon side wall 28 is oxidized to a depth, e.g., about 0.2 µm, sufficient to withstand the breakdown voltage, and accordingly, an oxide portion 31 is obtained as shown in Fig. 4E.

After removing the Si₃N₄ film 24, an aluminum wiring or interconnection pattern 32 is formed on the pillar-shaped silicon 25 and the PSG film 30 as shown in Fig. 4F. This formation of the aluminum wiring pattern 32 does not require a formation of a contact hole in the PSG film 30, and,as this technique does not require a mask alignment, the head surface portion of the pillar shaped silicon 25 can be narrowed, whereby the aluminum wiring 32 can be formed by a self alignment process. Further, a sufficient breakdown voltage property between the aluminum wiring 22 and the polysilicon side wall 28 is provided by the above-explained oxidizing treatment.

In this example impurity doped regions are usually and optionally formed in the silicon substrate 1 and the pillar shaped silicon 3 during the process of the present invention;further, although in this example a breakdown voltage property is enhanced by oxidizing the polysilicon, it may be also enhanced by nitriding the polysilicon. In such a case, a film having an anti-nitriding property, such as an oxide film, must be formed on the surface of the pillar-shaped silicon.

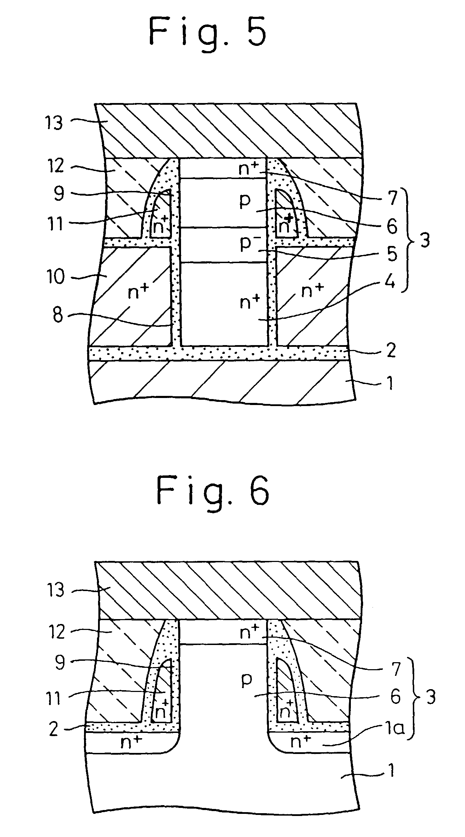

Figures 5 and 6 show cross sectional views of respective examples of a DRAM and a ROM produced according to the present invention. In these two examples, bit lines 13 are formed on a pillar shaped silicon 3 by a self-alignment process. Further, the upper portion of a gate insulating film (SiO₂) 9 obtained by the additional oxidizing process is thick. The other structural elements are substantially the same as shown in Figs. 1 and 2.

As explained above, according to the present invention, wiring can be easily brought into contact with a surface of a semiconductor pillar formed or a substrate, by a self alignment process, without positioning, with the result that a miniaturization of a device can be realized and the costs reduced.

## Claims

1. A method of producing a semiconductor device, comprising the steps of:
preparing a semiconductor substrate (1),
forming a semiconductor pillar (3,25) projecting from the semiconductor substrate so as to have a head portion surface and a circumferential surface,
forming a first insulating layer (24) on the head portion surface of the semiconductor pillar,
forming a second insulating layer (9,27) on the circumferential surface of the semiconductor pillar,
forming a conductive side wall (11,28) on the circumference of the semiconductor pillar (3,25) on the second insulating layer (9,27),
forming a third insulating layer (29), of a material different from that of the first insulating layer, on the surface of the conductive side wall (11,28),
forming a fourth insulating layer (12,30), of a material different from that of the first insulating layer (24), on the entire exposed surface so that the semiconductor pillar and the conductive side wall are buried,
removing the fourth insulating layer (12,30) to the level of the first insulating layer (24) on the head portion surface of the semiconductor pillar,
selectively growing a layer of insulation on the upper portion of the conductive side wall (11,28), without causing such growth on the semiconductor pillar, by using the first insulating layer (24) as a mask, whereby the breakdown voltage between the conductive side wall (11,28) and other elements is improved,
removing at least one part of the first insulating layer (24) formed on the head portion of the semiconductor pillar, and
forming a conductive pattern (13,32) on the head portion of the semiconductor pillar and the fourth insulating layer.

2. A method according to claim 1, wherein the substrate is a silicon substrate.

3. A method according to claim 1 or 2, wherein the semiconductor pillar (3,25) is made of silicon.

4. A method according to any of claims 1 to 3, wherein the first insulating layer (24) is a silicon nitride layer and the insulator (31) obtained by selective growth on the upper portion of the conductive side wall (11,28) is of silicon oxide formed by oxidation of the side wall.

5. A method according to any of claims 1 to 3, wherein the first insulating layer is a silicon oxide layer and the insulator obtained by selective growth on the upper portion of the conductive side wall is a nitride.

## Patentansprüche

1. Verfahren zur Herstellung einer Halbleitervorrichtung mit den folgenden Schritten:
Vorbereiten eines Halbleitersubstrats (1),
Bilden einer Halbleitersäule (3, 25), die von dem
Halbleitersubstrat so vorsteht, daß sie eine Kopfabschnittsoberfläche und eine Umfangsoberfläche hat,
Bilden einer ersten isolierenden Schicht (24) auf der Kopfabschnittoberfläche und der Halbleitersäule,
Bilden einer zweiten isolierenden Schicht (9, 27) auf der Umfangsoberfläche der Halbleitersäule,
Bilden einer leitenden Seitenwand (11, 28) auf dem Umfang der Halbleitersäule (3, 25) auf der zweiten isolierenden Schicht (9, 27),
Bilden einer dritten isolierenden Schicht (29), aus einem Material, das von demjenigen der ersten isolierenden Schicht verschieden ist, auf der Oberfläche der leitenden Seitenwand (11, 28),
Bilden einer vierten isolierenden Schicht (12, 30) aus einem Material, das von jenem der ersten isolierenden Schicht (24) verschieden ist, auf der gesamten exponierten Oberfläche, so daß die Halbleitersäule und die leitende Seitenwand vergraben werden,
Entfernen der vierten isolierenden Schicht (12, 30) zu dem Pegel der ersten isolierenden Schicht (24) auf der Kopfabschnittsoberfläche der Halbleitersäule,
selektives Wachsen einer Isolationsschicht auf dem oberen Abschnitt der leitenden Seitenwand (11, 28), ohne ein solches Wachstum auf der Halbleitersäule zu verursachen, durch Verwendung der ersten isolierenden Schicht (24) als eine Maske, wodurch die Durchbruchsspannung zwischen der leitenden Seitenwand (11, 28) und anderen Elementen verbessert wird,
Entfernen wenigstens eines Teiles der ersten isolierenden Schicht (24), die auf dem Kopfabschnitt der Halbleitersäule gebildet ist, und
Bilden eines leitenden Muster (13, 32) auf dem Kopfabschnitt der Halbleitersäule und der vierten isolierenden Schicht.

2. Verfahren nach Anspruch 1, bei dem das Substrat ein Siliziumsubstrat ist.

3. Verfahren nach Anspruch 1 oder 2, bei dem die Halbleitersäule (3, 25) aus Silizium besteht.

4. Verfahren nach einem der Ansprüche 1 bis 3, bei dem die erste isolierende Schicht (24) eine Siliziumnitridschicht ist und der Isolator, der durch selektives Wachstum auf dem oberen Abschnitt der leitenden Seitenwand (11, 28) erhalten wurde, aus Siliziumoxid ist, welches durch Oxidation der Seitenwand gebildet wurde.

5. Verfahren nach einem der Ansprüche 1 bis 3, bei dem die erste isolierende Schicht eine Siliziumoxidschicht ist, und der Isolator, der durch selektives Wachstum auf dem oberen Abschnitt der leitenden Seitenwand erhalten wurde, ein Nitrid ist.

## Revendications

1. Procédé pour produire un dispositif à semiconducteur , comprenant les étapes consistant à:
- élaborer un substrat de semiconducteur (1):
- former un pilier de semiconducteur (3, 25) faisant saillie sur le substrat de semiconducteur de manière à avoir une surface de partie de tête et une surface circonférentielle;
- former un première couche isolante (24) sur la surface de la partie de tête du pilier de semiconducteur;
- former une deuxième couche isolante (9, 27) sur la surface circonférentielle du pilier de semiconducteur;
- former une paroi latérale conductrice (11, 28) sur la circonférence du pilier de semiconducteur (3, 25) sur la deuxième couche isolante (9, 27);
- former une troisième couche isolante (29), d'une matière différente de celle de la première couche isolante, sur la surface de la paroi latérale conductrice (11, 28);
- former une quatrième couche isolante (12, 30), d'une matière différente de celle de la première couche isolante (24), sur toute la surface exposée de telle manière que le pilier de semiconducteur et la paroi latérale conductrice soient enterrés;
- éliminer la quatrième couche isolante (12, 30) jusqu'au niveau de la première couche isolante (24) sur la surface de la partie de tête du pilier de semiconducteur;
- faire croître sélectivement une couche d'isolant sur la partie supérieure de la partie conductrice (11, 28), sans provoquer une telle croissance sur le pilier de semiconducteur, en utilisant la première couche isolante (24) comme masque, ce par quoi la tension de claquage entre la paroi latérale conductrice (11, 28) et les autres éléments est améliorée,
- éliminer au moins une partie de la première couche isolante (24) formée sur la partie de tête du pilier de semiconducteur; et
- former un motif conducteur (13, 32) sur la partie de tête du pilier de semioconducteur et la quatrième couche isolante.

2. Procédé selon la revendication 1, dans lequel le substrat est un substrat de silicium.

3. Procédé selon la revendication 1 ou 2, dans lequel le pilier de semiconducteur (3, 25) est constitué de silicium.

4. Procédé selon l'une quelconque des revendications 1 à 3, dans lequel la première couche isolante (24) est une couche de nitrure de silicium et l'isolant (31) obtenu par croissance sélective sur la partie supérieure de la paroi latérale conductrice 11, 28 est en oxyde de silicium formé par oxydation de la paroi latérale.

5. Procédé selon l'une quelconque des revendications 1 à 3, dans leuqel la première couche isolante est une couche d'oxyde de silicium et l'isolant obtenu par croissance sélective sur la partie supérieure de la paroi latérale conductrice est un nitrure.
